# EUROPEAN PATENT APPLICATION

(11) **EP 2 775 533 A2**
(43) Date of publication of application: **10.09.2014**
(21) Application number: 14000770.9
(22) Date of filing: 04.03.2014
(51) Int. Cl.: H01L 31/0216, H01L 31/0224, H01L 31/0236, H01L 31/068

(54) **Solar cell**

(30) Priority: 05.03.2013 KR 20130023572
(71) Applicant: LG Electronics, Inc., Seoul 150-721 (KR)
(72) Inventor: Yang, Doohwan, 137-724 Seoul (KR); Yang, Juhong, 137-724 Seoul (KR); Jung, Ilhyoung, 137-724 Seoul (KR); KIM, Jinah, 137-724 Seoul (KR)
(74) Representative: Katérle, Axel

(57) **Abstract**

A solar cell is disclosed. The solar cell includes a semiconductor substrate (110), a conductive region (20, 30) formed at the semiconductor substrate and having a conductive type identical to or different from that of the semiconductor substrate, a passivation film (22, 32) formed on the semiconductor substrate so as to cover the conductive region, and an electrode (24, 34) electrically connected to at least one of the semiconductor substrate and the conductive region. The passivation film includes a first layer (22a, 32a) formed on the conductive region and including silicon oxide, a second layer (22b, 32b) formed on the first layer and including an oxide having a negative charge, and a third layer (22c, 32c) formed on the second layer and having an index of refraction different from that of the second layer.

## Description

### CROSS-REFERENCE TO RELATED APPLICATION

This application claims the priority benefit of Korean Patent Application No.10-2013-0023572, filed on March 5, 2013 in the Korean Intellectual Property Office, the disclosure of which is incorporated herein by reference.

### BACKGROUND OF THE INVENTION

### 1. Field of the Invention

Embodiments of the invention relate to solar cells, and more particularly to solar cells having an improved structure.

### 2. Description of the Related Art

Recently, as existing energy resources such as petroleum and coal are running out, interest in alternative energy sources is increasing. In particular, solar cells, which directly convert solar energy into electric energy, are receiving much attention as a next-generation alternative energy source.

These solar cells may be manufactured by forming various layers and electrodes according to designs. In this regard, solar cell efficiency may be determined according to the designs of various layers and electrodes. For widespread use of solar cells, low efficiency thereof needs to be overcome. Therefore, there is a need to develop a method of manufacturing a solar cell having maximized efficiency through designs of various layers and electrodes.

### SUMMARY OF THE INVENTION

Embodiments of the invention provide solar cells having maximized efficiency.

In one embodiment, a solar cell includes a semiconductor substrate, a conductive region formed at the semiconductor substrate and having a conductive type identical to or different from that of the semiconductor substrate, a passivation film formed on the semiconductor substrate so as to cover the conductive region, and an electrode electrically connected to at least one of the semiconductor substrate and the conductive region. The passivation film includes a first layer formed on the conductive region and including silicon oxide, a second layer formed on the first layer and including an oxide having a negative charge, and a third layer formed on the second layer and having a different index of refraction than the second layer.

In another embodiment, a solar cell includes a semiconductor substrate, a first conductive region formed at a first surface of the semiconductor substrate and having a first conductive type, a second conductive region formed at a second surface of the semiconductor substrate and having a second conductive type opposite the first conductive type, a first passivation film formed on the first surface of the semiconductor substrate so as to cover the first conductive region, a second passivation film formed on the second surface of the semiconductor substrate so as to cover the second conductive region, a first electrode electrically connected to the first conductive region, and a second electrode electrically connected to the second conductive region. The first passivation film includes a first silicon oxide layer formed on the first surface of the semiconductor substrate, a first silicon nitride layer formed on the first silicon oxide layer, and a second silicon oxide layer formed on the silicon nitride layer. The second passivation film includes a third silicon oxide layer formed on the second surface of the semiconductor substrate, a negatively charged oxide layer formed on the first silicon oxide layer and including a negatively charged oxide, a fourth silicon oxide layer formed on the negatively charged oxide layer, and a second silicon nitride layer formed on the fourth silicon oxide layer.

In another embodiment, a solar cell includes a semiconductor substrate, a conductive region formed at the semiconductor substrate and having a conductive type identical to or different from that of the semiconductor substrate, a passivation film formed on the semiconductor substrate so as to cover the conductive region, and an electrode electrically connected to at least one of the semiconductor substrate and the conductive region. The passivation film includes a first layer formed on the semiconductor substrate and a second layer formed on the first layer. The first layer has a smaller coefficient of thermal expansion than the semiconductor substrate and a greater coefficient of thermal expansion than the second layer, the first layer has a smaller thickness than the second layer, and the first layer has a higher interface trap density than the second layer.

### BRIEF DESCRIPTION OF THE DRAWINGS

Details of the embodiments of the invention will be more clearly understood from the following detailed description taken in conjunction with the accompanying drawings, in which:
FIG. 1 is a sectional view of a solar cell according to an embodiment of the invention;
FIG. 2 is a plan view of a solar cell according to an embodiment of the invention;
FIG. 3 is a flowchart illustrating a method of manufacturing a solar cell according to an embodiment of the invention; and
FIGS. 4A to 4G are sectional views sequentially illustrating a method of manufacturing a solar cell, according to an embodiment of the invention.

### DETAILED DESCRIPTION OF EMBODIMENTS

Reference will now be made in detail to embodiments, examples of which are illustrated in the accompanying drawings. However, the invention may be embodied in many different forms and should not be construed as limited to the embodiments set forth herein.

Elements constituting features of the embodiments of the invention are illustrated in the accompanying drawings and elements that are not features of the embodiments of the invention are omitted from the drawings for clarity of description. Like reference numerals refer to like elements throughout. In the drawings, widths, thicknesses, etc. of constituent elements may be exaggerated or reduced for clarity and convenience of illustration. The embodiments of the invention are not limited to the illustrated thicknesses, widths, etc.

It will be further understood that, throughout this specification, when one element is referred to as "comprising" another element, the term "comprising" specifies the presence of another element but does not preclude the presence of other additional elements, unless context clearly indicates otherwise. In addition, it will be understood that when one element such as a layer, a film, a region or a plate is referred to as being "on" another element, the one element may be directly on the other element and one or more intervening elements may also be present. In contrast, when one element such as a layer, a film, a region or a plate is referred to as being "directly on" another element, one or more intervening elements are not present.

Hereinafter, a solar cell according to an embodiment of the invention and a method of manufacturing the same will be described in detail with reference to the accompanying drawings.

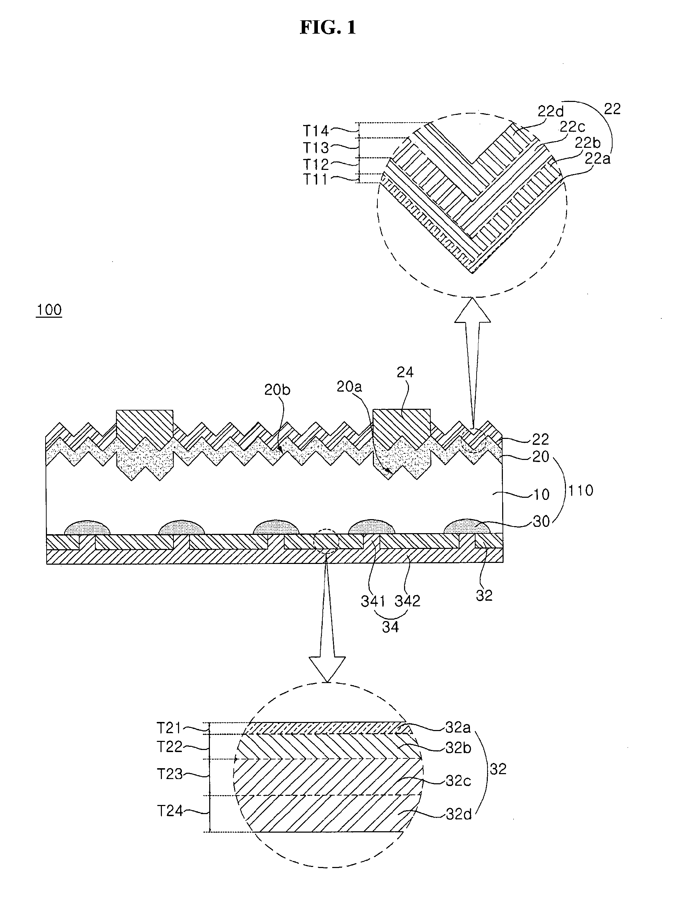

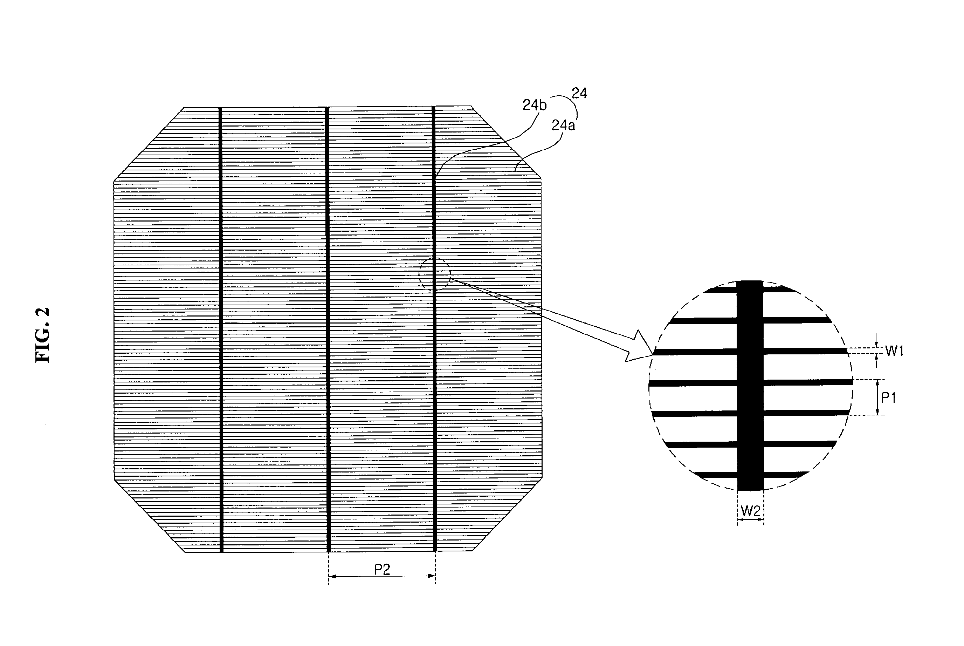

FIG. 1 is a sectional view of a solar cell 100 according to an embodiment of the invention. FIG. 2 is a plan view of the solar cell 100 of FIG. 1.

Referring to FIG. 1, the solar cell 100 according to the present embodiment may include a substrate 110 (e.g., a semiconductor substrate, hereinafter referred to as a "semiconductor substrate"), conductive regions 20 and 30 formed at the semiconductor substrate 110, and electrodes 24 and 34 electrically connected to the conductive regions 20 and 30, respectively. In addition, the solar cell 100 may include at least one of a first passivation film 22 and a second passivation film 32 that are formed on surfaces of the semiconductor substrate 110. The conductive regions 20 and 30 may include an emitter region 20, which is of a first conductive type, and back surface field regions 30, which are of a second conductive type, and the electrodes 24 and 34 may include first electrodes 24 electrically connected to the emitter region 20 and a second electrode 34 electrically connected to the back surface field regions 30. This will be described in further detail.

The semiconductor substrate 110 includes an area in which the conductive regions 20 and 30 are formed and a base region 10, which is a portion in which the conductive regions 20 and 30 are not formed. The base region 10 may include, for example, silicon containing a second conductive type impurity. The silicon may be mono-crystalline silicon or polycrystalline silicon, and the second conductive type impurity may be, for example, a p-type impurity. That is, the base region 10 may be made of mono-crystalline or polycrystalline silicon that is low-doped with a Group III element such as boron (B), aluminum (Al), gallium (Ga), indium (In), or the like.

In the present embodiment, the semiconductor substrate 110 is p-type conductive and thus the back surface field regions 30 of p-type conductivity may be easily formed at a back surface of the semiconductor substrate 110. That is, the back surface field regions 30 are formed by heat treatment after forming the second electrode 34, whereby manufacturing processes may be simplified. This will be described below in more detail. However, the embodiments of the invention are not limited to the above-described examples. That is, the base region 10 and the back surface field regions 30 may be of an n-type and the emitter region 20 may be of a p-type.

A front surface of the semiconductor substrate 110 may be textured to have an uneven portion in the form of a pyramid, or the like. Through the texturing process, the uneven portion is formed at the front surface of the semiconductor substrate 110 and thus surface roughness thereof increases, whereby reflectance of light incident upon the front surface of the semiconductor substrate 110 may be reduced. Accordingly, the amount of light reaching a pn junction formed at an interface between the semiconductor substrate 110 and the emitter region 20 may be increased and, consequently, light loss may be minimized. Meanwhile, the back surface of the semiconductor substrate 110 may be a relatively smooth and even surface formed by mirror polishing or the like and having a lower surface roughness than the front surface of the semiconductor substrate 110. Accordingly, light having passed through the semiconductor substrate 110 and directed towards the back surface thereof may be directed back towards the semiconductor substrate 110 by reflection from the back surface of the semiconductor substrate 110. Thus, the amount of light reaching the pn junction is increased and, accordingly, efficiency of the solar cell 100 may be enhanced.

The semiconductor substrate 110 may be provided at the front surface thereof with the emitter region 20 having a first conductive type impurity. In the present embodiment, the first conductive type impurity of the emitter region 20 may be an n-type impurity, for example, a Group V element such as phosphorus (P), arsenic (As), bismuth (Bi), antimony (Sb), or the like.

In this regard, in the present embodiment, the emitter region 20 may have first portions 20a having a high impurity concentration and a relatively low resistance and second portions 20b having a lower impurity concentration than the first portions 20a and a relatively high resistance. The first portions 20a partially or completely (i.e., at least partially) contact the respective first electrodes 24.

As such, in the present embodiment, the second portions 20b, having a relatively high resistance, are formed in a portion corresponding to a region between the first electrodes 24, thereby forming a shallow emitter. Accordingly, current density of the solar cell 100 may be enhanced. In addition, the first portions 20a, having a relatively low resistance, are formed adjacent to the respective first electrodes 24 and, accordingly, contact resistance with the first electrodes 24 may be reduced. That is, the emitter region 20 according to the present embodiment may maximize efficiency of the solar cell 100 by a selective emitter structure thereof.

However, the embodiments of the invention are not limited to the above example. That is, the emitter region 20 may have a homogenous emitter structure having a uniform doping concentration. In addition, the emitter region 20 may have various other structures. For example, the emitter region 20 may also be formed on the back surface of the semiconductor substrate 110.

On the semiconductor substrate, more particularly on the emitter region 20 formed at the semiconductor substrate 110, are formed the first passivation film 22 and the first electrodes 24.

The first passivation film 22 may be substantially formed over the entire front surface of the semiconductor substrate 110, not on portions corresponding to the first electrodes 24. In the present embodiment, the first passivation film 22 serves to passivate the front surface of the semiconductor substrate 110 and acts as an anti-reflective film. That is, the first passivation film 22 inactivates defects present at the surface or bulk of the emitter region 20 and reduces reflectance of light incident upon the front surface of the semiconductor substrate 110.

Since the first passivation film 22 inactivates defects present at the emitter region 20, recombination sites of minority carriers are removed and thus an open circuit voltage (Voc) of the solar cell 100 may be increased. In addition, since the first passivation film 22 reduces reflectance of light incident upon the front surface of the semiconductor substrate 110, the amount of light reaching the pn junction formed at the interface between the semiconductor substrate 110 and the emitter region 20 may be increased. Accordingly, a short-circuit current Isc of the solar cell 100 may be increased. As such, the open circuit voltage (Voc) and the short-circuit current Isc of the solar cell 100 may be increased by the first passivation film 22 and, accordingly, the efficiency of the solar cell 100 may be enhanced.

In the present embodiment, to effectively implement the functions described above, the first passivation film 22 may have a structure in which various layers are stacked. This will be described below in detail.

The first electrodes 24 are electrically connected to the emitter region 20 via openings formed in the first passivation film 22 (i.e., through the first passivation film 22). The first electrodes 24 may be formed of various materials so as to have various shapes.

As illustrated in FIG. 2, each first electrode 24 may include, for example, a plurality of finger electrodes 24a having a first pitch P1 and arranged in parallel. In addition, each first electrode 24 may include bus bar electrodes 24b formed in a direction crossing the finger electrodes 24a and connecting the finger electrodes 24a to one another. In this regard, a single bus bar electrode 24b may be disposed or, as illustrated in FIG. 2, plural bus bar electrodes 24b having a second pitch P2 that is greater than the first pitch P1 may be disposed. The bus bar electrode 24b may have a width W2 that is greater than a width W1 of the finger electrode 24a, but the embodiments of the invention are not limited thereto. For example, the bus bar electrode 24b may have the same or smaller width than the first electrode 24a. In addition, various modifications are possible. For example, the bus bar electrodes 24b may not be formed. The shape of the first electrodes 24 is provided for illustrative purposes only, and the embodiments of the invention are not limited thereto.

As seen in a sectional view, the finger electrodes 24a and the bus bar electrodes 24b may be formed through the first passivation film 22. In another embodiment, the finger electrodes 24a may be formed through the first passivation film 22 and the bus bar electrodes 24b may be formed on the first passivation film 22.

Referring back to FIG. 1, the semiconductor substrate 10 is provided at a back surface thereof with the back surface field regions 30 containing a second conductive type impurity at a higher doping concentration than the semiconductor substrate 110. Due to the back surface field regions 30, electrons and holes are recombined at the back surface of the semiconductor substrate 110 and thus loss of carriers may be prevented or reduced. In the present embodiment, the second conductive type impurity of the back surface field regions 30 may be a p-type impurity, e.g., a Group III element such as boron (B), aluminum (Al), gallium (Ga), indium (In), or the like.

In the present embodiment, the back surface field regions 30 may have a local back surface field structure partially formed at a portion adjacent to the second electrode 34. In such a configuration, the back surface field regions 30 may be formed when forming the second electrode 34 and thus manufacturing processes may be simplified. However, the embodiments of the invention are not limited thereto. That is, the back surface field regions 30 may be separately formed from the second electrode 34. In addition, the back surface field regions 30 may have a selective back surface field structure such that a portion of the back surface field region 30, adjacent to the second electrode 34, has a relatively high doping concentration and a portion thereof not adjacent to the second electrode 34 has a relatively low doping concentration. In another embodiment, the back surface field regions 30 may have a homogenous back surface field structure such that the back surface field region 30 is formed at the entire back surface of the semiconductor substrate 110 so as to have a homogenous doping concentration.

The semiconductor substrate 110 may be provided at the back surface thereof with the second passivation film 32 and the second electrode 34.

The second passivation film 32 may be formed on substantially the entire back surface of the semiconductor substrate 110, except for regions where the second electrode 34 is formed. The second passivation film 32 may inactivate defects present in the back surface of the semiconductor substrate 110, thereby removing recombination sites of minority carriers. Thus, the open circuit voltage of the solar cell 100 may be increased. In addition, in the present embodiment, the second passivation film 32 is configured to be highly reflective so that light having passed through the semiconductor substrate 110 is easily reflected from the second passivation film 32 or the second electrode 34, which enables reuse of light.

In the present embodiment, to effectively implement the above-described functions, the second passivation film 32 may have a structure in which a variety of layers are stacked. This will be described below in detail.

The second electrode 34 is electrically connected to the back surface field regions 30 via openings formed in the second passivation film 32 (i.e., through the second passivation film 32). The second electrode 34 may be formed so as to have various shapes.

In an embodiment of the invention, the second electrode 34 is entirely formed on the second passivation film 32 and electrically connected to the back surface field regions 30 (or the semiconductor substrate 110) via openings formed in the second passivation film 32. That is, in the present embodiment, the second electrode 34 may include first electrode parts 341 respectively connected to the back surface field regions 30 through the second passivation film 32 and a second electrode part 342 connected to the first electrode parts 341 and entirely formed on the second passivation film 32. In this regard, the first electrode parts 341 may be in point contact with the back surface field regions 30, but the embodiments of the invention are not limited thereto. That is, the first electrode parts 341 may be connected to the back surface field regions 30 by various contact methods, various structures, various shapes, or the like.

As such, the second electrode 34 includes the second electrode part 342 entirely formed on the second passivation film 32 and thus light having passed through the semiconductor substrate 110 is reflected thereby, which enables reuse of light. In addition, carriers formed by photoelectric conversion may be effectively collected by the first electrode parts 341. Accordingly, the efficiency of the solar cell 100 may be enhanced. However, the embodiments of the invention are not limited to the above example. For example, the second electrode 34 has a similar shape to that of the first electrodes 24, which enables opposite surfaces thereof to receive light. In addition, various modifications of the second electrode 34 are possible.

As described above, in the present embodiment, due to the stacked structure of the first passivation film 22 formed on the front surface of the semiconductor substrate 110 and the second passivation film 32 formed on the back surface of the semiconductor substrate 110, efficiency and characteristics of the solar cell 100 are further enhanced. This will be described in detail. Hereinafter, the second passivation film 32 will be described before the first passivation film 22.

Referring to an enlarged circle of FIG. 1, the second passivation film 32 includes a first layer 32a and a second layer 32b that are sequentially stacked on the back surface of the semiconductor substrate 110. In addition, the second passivation film 32 may further include a third layer 32c and a fourth layer 32d that are formed on the second layer 32b.

In this regard, the first layer 32a is a layer formed on the semiconductor substrate 110 and, for example, may contact the semiconductor substrate 110. The second layer 32b is a layer formed on the first layer 32a and, for example, may contact the first layer 32a.

In this regard, the second layer 32b may include an oxide having a negative charge thus being suitable for passivation of the back surface field regions 30 of a p-type. For example, the second layer 32b may be an oxide layer including at least one material selected from the group consisting of aluminum oxide, hafnium oxide, and zirconium oxide. These oxides have a larger amount of negative charges than other materials used for formation of a passivation film and thus may induce field effect passivation. Due to such field effect passivation, passivation of the back surface field regions 30 of a p-type may be effectively implemented. Among the first, second, third and fourth layers 32a, 32b, 32c and 32d, the second layer 32b may include aluminum oxide. That is, the second layer 32b of the second passivation film 32 is a negatively charged oxide layer and a layer that effectively passivates the back surface field regions 30 of a p-type by field effect passivation.

In this regard, the second layer 32b may have a thickness T22 of 4 nm to 20 nm. When the thickness T22 of the second layer 32b is less than 4 nm, passivation effects may be insufficient. On the other hand, when the thickness T22 of the second layer 32b exceeds 20 nm, manufacturing time may be increased and blistering may occur. The term "blistering" as used herein refers to a phenomenon in which the second passivation film 32 is inflated in a process of forming the second passivation film 32 or a subsequent process (in particular, a heat treatment process). Blistering may occur for various reasons, e.g., hydrogen included in the second layer 32b. That is, while the second layer 32b has excellent field effect passivation properties due to negative charges, a large amount of hydrogen may be introduced into the second layer 32b when forming the second layer 32b and, accordingly, blistering may easily occur in a high-temperature process. When such blistering occurs, a passivation film is inflated and thus it is difficult to exhibit sufficient passivation effects and, accordingly, packing density of the solar cell 100 may be reduced.

The second layer 32b may be formed by, for example, atomic layer deposition (ALD), but the embodiments of the invention are not limited thereto. That is, the second layer 32b may be formed using various methods.

Accordingly, in the present embodiment, the first layer 32a, which serves to prevent blistering, is formed between the semiconductor substrate 110 and the second layer 32b. In addition, the first layer 32a acts as a thermal buffer for complementing a difference between thermal properties of the semiconductor substrate 110 and the second layer 32b.

For this operation, the first layer 32a may include a material having a coefficient of thermal expansion between coefficients of thermal expansion of the semiconductor substrate 110 and the second layer 32b, having a greater interface trap density than the second layer 32b and the third layer 32c, and having neutrality so as not to affect field effect passivation of the second layer 32b. In addition, the first layer 32a may be thinner than the second layer 32b and thus does not affect field effect passivation of the second layer 32b. In this regard, a thickness T21 of the first layer 32a may be smaller than a thickness T23 of the third layer 32c and a thickness T24 of the fourth layer 32d.

In particular, the coefficient of thermal expansion of the first layer 32a may be smaller than a coefficient of thermal expansion of the semiconductor substrate 110 and a coefficient of thermal expansion of the second layer 32b. For example, the first layer 32a may have a coefficient of thermal expansion of 0.3 X 10⁻⁶ m/°C to 3.5 X 10⁻⁶ m/°C, considering that the semiconductor substrate 110 has a coefficient of thermal expansion of approximately 4 X 10⁻⁶ m/°C and the second layer 32b has a coefficient of thermal expansion of approximately 0.3 X 10⁻⁶ m/°C when including aluminum oxide. When the first layer 32a has a coefficient of thermal expansion within the above-described range, problems due to a difference between the coefficients of thermal expansion of the semiconductor substrate 110 and the second layer 32b may be prevented. However, the embodiments of the invention are not limited to the above example and the numerical range of the coefficient of thermal expansion of the first layer 32a may vary in consideration of materials of the semiconductor substrate 110 and the second layer 32b, and the like.

In addition, the first layer 32a may have a thickness so as not to affect field effect passivation of the second layer 32b. For example, a ratio of the thickness T21 of the first layer 32a to the thickness T22 of the second layer 32b may be 1:4 to 1:12 (more particularly, 1:4 to 1:6). The thickness ratio is determined so as not to affect field effect passivation and so as to prevent blistering of the second layer 32b and implement function as a thermal buffer. However, the embodiments of the invention are not limited to the above example and a thickness ratio of the first layer 32a to the second layer 32b may also vary.

In this regard, the thickness T21 of the first layer 32a may be 1 nm to 5 nm. When the thickness T21 of the first layer 32a is less than 1 nm, it may be difficult to prevent occurrence of blistering of the second layer 32b and for the first layer 32a to act as a thermal buffer. On the other hand, when the thickness T21 of the first layer 32a exceeds 5 nm, field effect passivation effects of the second layer 32b may be reduced.

To form the first layer 32a to such a small thickness, the first layer 32a may be formed by thermal deposition. That is, the first layer 32a may be a thermal oxide layer. In this regard, silicon oxide, which is an oxide containing silicon, constituting the semiconductor substrate 110 is a material having the coefficient of thermal expansion as described above and neutrality and thus the first layer 32a may be formed of silicon oxide. In such a configuration, the first layer 32a may be easily formed by thermally oxidizing the semiconductor substrate 110.

As such, when the first layer 32a is formed of a thermal oxide, a somewhat unstable silicon oxide having a smaller amount of oxygen atoms than oxides formed by deposition or the like (e.g., silicon oxides formed of the same material) is formed. In addition, the first layer 32a may have a greater interface trap density than the other layers constituting the second passivation film 32 (i.e., the second layer 32b, the third layer 32c, and the fourth layer 32d). That is, the first layer 32a may have a relatively high interface trap density by including a smaller amount of oxygen (O) atoms than SiO₂, which is a stable silicon oxide. As such, when the amount of oxygen atoms is reduced, hydrogen in the second layer 32b diffuses into the first layer 32a, which is somewhat unstable. Accordingly, the amount of hydrogen in the second layer 32b may be reduced and thus occurrence of blistering in the second layer 32b may be effectively prevented. More particularly, when a larger amount of hydrogen than the amount of hydrogen filling defects (e.g., a dangling bond) is included in the second passivation film 32, the remaining hydrogen reacts with another gas or the like or exists alone in the form of a gas and thus blistering may occur while exploding. Considering this, in the present embodiment, the first layer 32a is formed between the semiconductor substrate 110 and the second layer 32b so as to diffuse the remaining hydrogen and thus oxygen remaining in the second layer 32b may be prevented or reduced, which results in prevention of blistering.

For example, the first layer 32a may have an interface trap density of 4.1 X 10¹¹ cm⁻² eV⁻¹ to 6 X 10¹¹ cm⁻² eV⁻¹. This range is provided as an example of appropriate density for diffusion of the remaining oxygen, but the embodiments of the invention are not limited thereto.

The third layer 32c having a different index of refraction than the second layer 32b may be formed on the second layer 32b. Since the third layer 32c has a different index of refraction than the second layer 32b, light having passed through the semiconductor substrate 110 may be easily reflected thereby. That is, the third layer 32c has a lower index of refraction than the second layer 32b and thus light may be reflected back to the semiconductor substrate 110 by total reflection.

For example, the second layer 32b may have an index of refraction of 1.6 to 1.8, and the third layer 32c may have an index of refraction of 1.4 to 1.6 that is lower than the second layer 32b. For example, the third layer 32c may include silicon oxide. As such, light having passed through the semiconductor substrate 110 may be effectively reflected by adjusting the indexes of refraction of the second and third layers 32b and 32c. In addition, the thickness T22 of the second layer 32b may be smaller than the thickness T23 of the third layer 32c. This is because, when the thickness T22 of the second layer 32b increases, blistering or the like occurs and productivity of the second layer 32b formed by ALD or the like may be reduced. For example, the thickness T23 of the third layer 32c may be 200 nm to 250 nm. Such thickness is limited to a range in which reflection characteristics may be maximized in consideration of index of refraction.

In this regard, the first layer 32a may be a thermal oxide layer, and the third layer 32c may be a silicon oxide layer formed by deposition (e.g, chemical vapor deposition (CVD) such as plasma-enhanced CVD (PECVD)). Thus, the interface trap density of the first layer 32a may be 1.5 to 5 times (more particularly, 2 to 3 times) that of the third layer 32c.

In addition, the fourth layer 32d to cap the first, second and third layers 32a, 32b and 32c may be formed on the third layer 32c. The fourth layer 32d serves to prevent a material for forming the second electrode 34 from diffusing into the second passivation film 32 or firing through the second passivation film 32, in an unnecessary portion, when forming the second electrode 34. The fourth layer 32d may include various materials, e.g., silicon nitride.

The thickness T24 of the fourth layer 32d is not particularly limited. For example, the fourth layer 32d may have a thickness T24 of 50 nm to 100 nm so as to serve as a capping layer and be formed within a short time.

In addition, the fourth layer 32d may have an index of refraction of 2.0 to 2.5. The index of refraction may be obtained by adjusting x of SiNₓ by adjustment of the amount of ammonia, which is a source gas for forming silicon nitride. Reflection of light may be further induced by such an index of refraction.

Meanwhile, referring to another enlarged circle of FIG. 1, the first passivation film 22 includes a first layer 22a, a second layer 22b, a third layer 22c, and a fourth layer 22d that are sequentially stacked on the semiconductor substrate 110.

In this regard, inclusion of the second layer 22b of the first passivation film 22 is not necessary. That is, in the present embodiment, the second passivation film 32 to passivate the back surface field regions 30 of a p-type includes the second layer 32b including an oxide having a negative charge for field effect passivation, while the first passivation film 22 to passivate the emitter region 20 of an n-type does not necessarily include the second layer 22b including an oxide having a negative charge. The second layer 22b of the first passivation film 22 may be formed without burdening the manufacturing processes since the second layer 22b may be formed together with the second layer 32b of the second passivation film 32. However, the embodiments of the invention are not limited to the above example. For example, when the emitter region 20 is of a p-type, the first passivation film 22 necessarily includes the second layer 22b.

In addition, the second layer 22b, the third layer 22c, and the fourth layer 22d have a constant index of refraction and thus front reflection is prevented or reduced.

The first and second layers 22a and 22b of the first passivation film 22 are similar to the first and second layers 32a and 32b of the second passivation film 32. This is because the first layer 22a of the first passivation film 22 and the first layer 32a of the second passivation film 32 are formed using the same manufacturing process and the second layer 22b of the first passivation film 22 and the second layer 32b of the second passivation film 32 are formed using the same manufacturing process. As such, at least a portion of the first and second passivation films 22 and 32 may be formed together, which results in simplified manufacturing processes. This will be described below.

In this regard, the first layer 22a of the first passivation film 22 may have a smaller thickness than the first layer 32a of the second passivation film 32. This is because the semiconductor substrate 10 is provided at a front surface thereof with irregularities. For example, the thickness T21 of the first layer 32a of the second passivation film 32 may be 1 nm to 5 nm, and the thickness T11 of the first layer 22a of the first passivation film 22 may be 1 nm to 4 nm. However, the embodiments of the invention are not limited thereto and the thicknesses T11 and T21 may be variously changed. In addition, a material of the first layer 22a and material, thickness and the like of the second layer 22b are the same or similar as in the second passivation film 32 and thus a detailed description thereof will be omitted herein.

In addition, the third and fourth layers 22c and 22d formed on the second layer 22b serve as an anti-reflective film for preventing or reducing reflection by adjustment of an index of refraction, a thickness, or the like. For example, the third layer 22c may have a greater index of refraction than the second layer 22b, and the fourth layer 22d may have a smaller index of refraction than the third layer 22c. To have such a difference between indexes of refraction of the third and fourth layers 22c and 22d, the third layer 22c may include silicon nitride and the fourth layer 22d may include silicon oxide. However, these materials are provided for illustrative purposes only and the third and fourth layers 22c and 22c may include various other materials. In this regard, an interface trap density of the first layer 22a may be 1.5 to 5 times that of the fourth layer 22d. This is considering that the first layer 22a is a thermal oxide layer and the third layer 22c is an oxide layer formed by deposition. However, the embodiments of the invention are not limited thereto.

For example, the second layer 22b may have an index of refraction of 1.6 to 1.8, the third layer 22c may have an index of refraction of 2.0 to 2.5, and the fourth layer 22d may have an index of refraction of 1.4 to 1.6. In addition, a thickness T12 of the second layer 22b may be smaller than a thickness T13 of the third layer 22c and a thickness T14 of the fourth layer 22d. For example, the thickness T12 of the second layer 22b may be 4 nm to 20 nm, the thickness T13 of the third layer 22c may be 80 nm to 90 nm, and the thickness T14 of the fourth layer 22d may be 100 nm to 120 nm. These thicknesses and indexes of refraction are optimized so as to prevent or reduce reflection. However, the embodiments of the invention are not limited to the above examples and the thicknesses and indexes of refraction of the second, third and fourth layers 22b, 22c and 22d may vary.

As such, in the present embodiment, various characteristics may be enhanced by improving a stacked structure of each of the first and second passivation films 22 and 32.

That is, dangling bonds may be removed by the first layer 22a of the first passivation film 22, and the first passivation film 22 may serve as an anti-reflective film by restricting the indexes of refraction of the second, third and fourth layers 22b, 22c and 22d.

In addition, the second layer 32b of the second passivation film 32 is formed as a negatively charged field oxide layer and thus the second passivation film 32 may effectively passivate the conductive regions 20 and 30 of a p-type (in the present embodiment, the back surface field regions 30). In this regard, the first layer 32a as a neutral film having a coefficient of thermal expansion between coefficients of thermal expansion of the semiconductor substrate 110 and the second layer 32b and having a high interface trap density is formed between the second layer 32b and the semiconductor substrate 110 and thus thermal properties may be enhanced and blistering of the second layer 32b may be prevented. In addition, reflection of light by back surfaces of the second and third layers 32b and 32c may be effectively implemented by adjusting indexes of refraction of the second and third layers 32b and 32c and thus light having passed through the semiconductor substrate 110 may be reused and, accordingly, the amount of light used may be increased. In addition, the fourth layer 32d acts as a capping layer and thus may prevent or reduce problems such as damage to the second passivation film 32 when forming the second electrode 34, and the like.

As such, in the present embodiment, the efficiency of the solar cell 100 may be maximized by optimizing the first passivation film 22 and/or the second passivation film 32. For example, the efficiency of the solar cell 100 may be increased by approximately 1% or greater, and power may be increased by 15 W or greater when manufacturing a solar cell module using the solar cell 100. Accordingly, price competitiveness of products may also be enhanced.

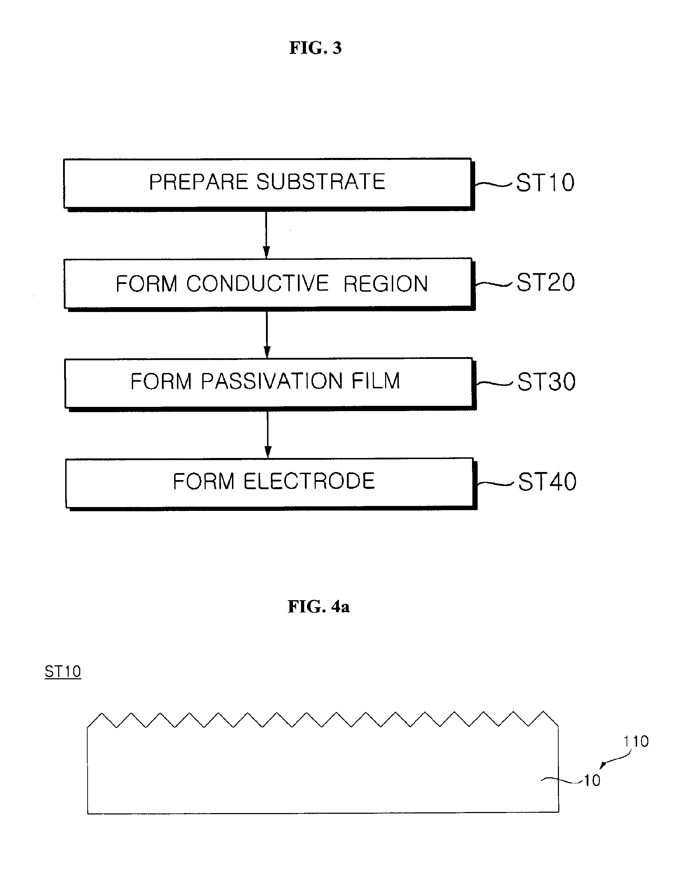

A method of manufacturing the solar cell 100 having the structure described above will now be described in detail with reference to FIGS. 4A to 4G. Hereinafter, a detailed description of elements that have already been described will be omitted herein and a detailed description of different elements will be provided herein.

FIG. 3 is a flowchart illustrating a method of manufacturing a solar cell, according to an embodiment of the invention. FIGS. 4A to 4G are sectional views sequentially illustrating the method of manufacturing a solar cell illustrated in FIG. 3.

Referring to FIG. 3, the method of manufacturing a solar cell according to the present embodiment includes preparing a substrate (step ST10), forming a conductive region (step ST20), forming a passivation film (step ST30), and forming an electrode (step ST40). Each step will now be described in detail with reference to FIGS. 4A to 4G.

First, as illustrated in FIG. 4A, in the preparing step (step ST10), the semiconductor substrate 110 having a second conductive type impurity and including the base region 10 is prepared. In the present embodiment, the semiconductor substrate 110 may be made of silicon having a p-type impurity. In this regard, a front surface of the semiconductor substrate 110 may be textured so as to have irregularities and a back surface thereof may have a lower surface roughness than the front surface thereof.

The texturing process may be wet texturing or dry texturing. Wet texturing may be performed by immersing the semiconductor substrate 110 in a texturing solution and is advantageous in that manufacturing time is short. Dry texturing is carried out by cutting a surface of the semiconductor substrate 110 using a diamond drill, a laser or the like. In dry texturing, irregularities may be uniformly formed, while manufacturing time is long and damage to the semiconductor substrate 110 may occur. In addition, the semiconductor substrate 110 may be textured by reactive ion etching (RIE) or the like. As such, the semiconductor substrate 110 may be textured using various methods. In addition, the back surface of the semiconductor substrate 110 may have excellent reflectance by mirror polishing or the like when forming the second electrode 34.

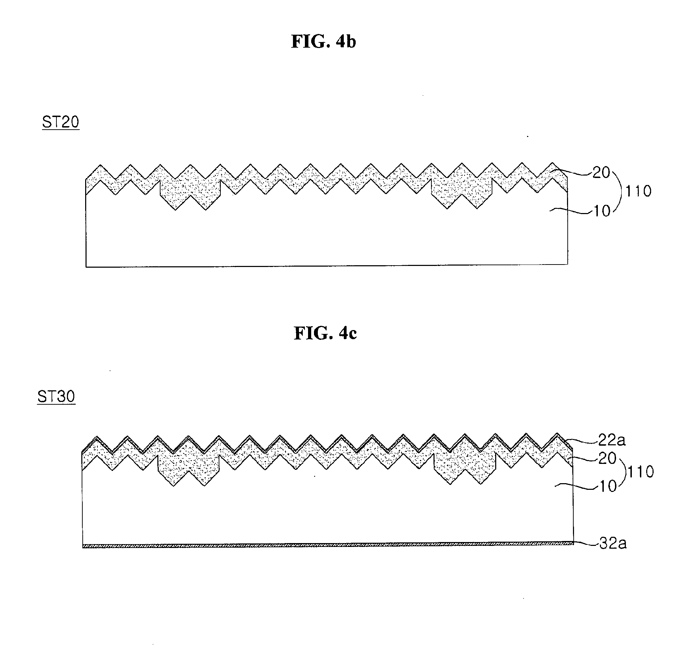

Subsequently, as illustrated in FIG. 4B, in the forming of the conductive region (step ST20), the emitter region 20, which is a conductive region, is formed. In the present embodiment, the emitter region 20 is first formed and the back surface field regions 30 are formed when forming the second electrode 34 and immediately therebefore, but the embodiments of the invention are not limited thereto. That is, at least a portion of the back surface field regions 30 may be formed in step ST20.

For example, the emitter region 20 may be formed by doping the semiconductor substrate 110 with a first conductive type impurity (e.g., an n-type impurity) by various methods such as ion implantation, thermal diffusion, or the like. In this regard, the emitter region 20 having a selective emitter structure and having the first portions 20a and the second portions 20b may be formed by doping the semiconductor substrate 110 with a first conductive type impurity a plurality of times or by ion implantation using a comb mask.

Subsequently, as illustrated in FIGS. 4C to 4F, in the forming of the passivation film (step ST30), the first passivation film 22 and the second passivation film 32 are respectively formed on the front and back surfaces of the semiconductor substrate 110. This will be described below in more detail.

First, as illustrated in FIG. 4C, the first layer 22a of the first passivation film 22 and the first layer 32a of the second passivation film 32 are formed on opposite surfaces of the semiconductor substrate 110. In this regard, the first layers 22a and 32a may be formed as a thermal oxide layer formed by thermally growing the semiconductor substrate 110 in a furnace at a high temperature. When the semiconductor substrate 110 includes silicon, the first layers 22a and 32a may be formed as a silicon oxide layer. Thus, the first layers 22a and 32a having a small thickness, a relatively low oxygen concentration, and a high interface trap density may be easily formed.

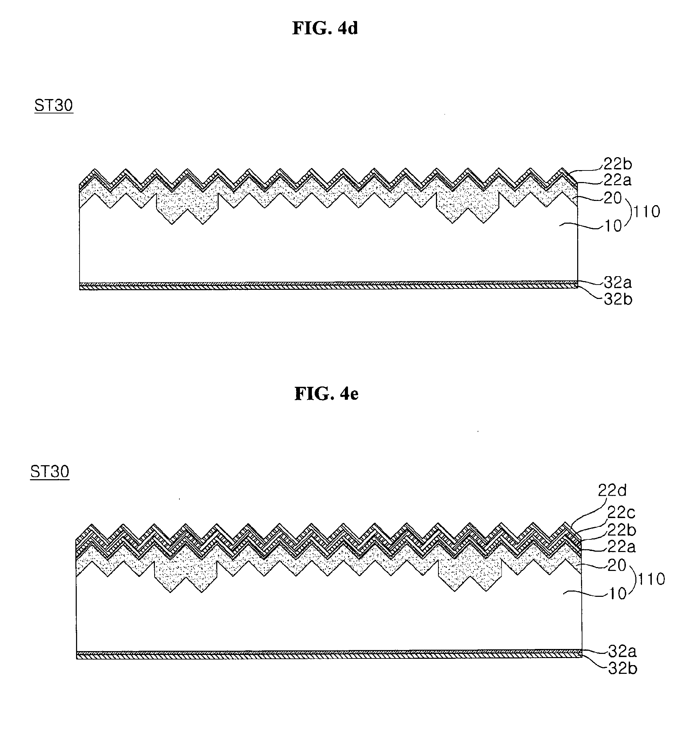

Subsequently, as illustrated in FIG. 4D, the second layer 22b of the first passivation film 22 and the second layer 32b of the second passivation film 32 are formed on opposite surfaces of the semiconductor substrate 110. In this regard, the second layers 22b and 32b may be formed of aluminum oxide, hafnium oxide, zirconium oxide, or the like for field effect passivation. The second layers 22b and 32b may be formed by ALD or the like.

In this regard, the second passivation film 32 to passivate the back surface field regions 30 of a p-type includes the second layer 32b, while the first passivation film 22 may not include the second layer 22b.

As such, at least a portion of the first and second passivation films 22 and 32 may be formed together and thus manufacturing processes may be simplified.

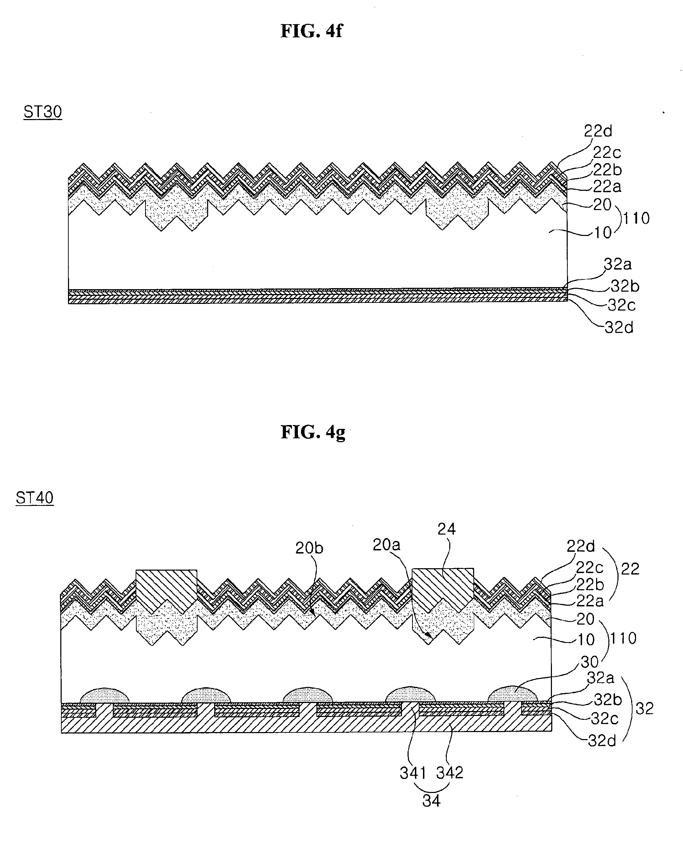

Subsequently, as illustrated in FIG. 4E, the third and fourth layers 22c and 22d of the first passivation film 22 are formed on the second layer 22b of the first passivation film 22. Subsequently, as illustrated in FIG. 4F, the third and fourth layers 32c and 32d of the second passivation film 32 are formed on the second layer 32b of the second passivation film 32. The third layer 22c of the first passivation film 22 may be a silicon nitride layer, and the fourth layer 22d thereof may be a silicon oxide layer. In addition, the third layer 32c of the second passivation film 32 may be a silicon oxide layer, and the fourth layer 32d thereof may be a silicon nitride layer.

The third layers 22c and 32c and the fourth layers 22d and 32d may be formed by various methods such as vacuum deposition, chemical vapor deposition, spin coating, screen-printing, spray coating, or the like. Thus, the third layers 22c and 32c and the fourth layers 22d and 32d may have a lower interface trap density than the first layers 22a and 32a, which are thermal oxide layers.

In the present embodiment, the third and fourth layers 22c and 22d of the first passivation film 22 are formed before the third and fourth layers 32c and 32d of the second passivation film 32, but the embodiments of the invention are not limited thereto. That is, the third and fourth layers 32c and 32d of the second passivation film 32 may be formed before the third and fourth layers 22c and 22d of the first passivation film 22. In addition, various modifications are possible.

Subsequently, as illustrated in FIG. 4G, in the forming of the electrode (step ST40), the first electrodes 24 contacting the emitter region 20 are formed on the front surface of the semiconductor substrate 110, and the second electrode 34 is formed on the back surface of the semiconductor substrate 110. In this regard, the back surface field regions 30 may be formed before forming the second electrode 34 or when forming the second electrode 34.

Openings may be formed in the first passivation film 22 and the first electrodes 24 may be formed in the openings by various methods such as plating, deposition, or the like. In addition, openings may be formed in the second passivation film 32 and the second electrode 34 may be formed in the openings by various methods such as plating, deposition, or the like.

In another embodiment, the first and second electrodes 24 and 34 having the above-described shapes may be formed by respectively coating pastes for forming first and second electrodes on the first and second passivation films 22 and 32 by screen-printing or the like and performing fire through, laser firing contact, or the like thereon. In this instance, a separate process of forming openings may not be needed or used. In addition, the second electrode 34 is formed of a metal such as aluminum or the like and thus aluminum in the second electrode 34 diffuses into the back surface of the semiconductor substrate 110 during a calcination process and, consequently, the back surface field regions 30 are formed.

The process of forming the second electrode 34 will be described in further detail. The second electrode part 342 may be formed over the second passivation film 32 and then the first electrode parts 341 may be formed by melting portions corresponding to the first electrode parts 341 by laser firing contact or the like. However, the embodiments of the invention are not limited to the above example. That is, the second electrode 34 may be formed by forming openings in the second passivation film 32 and entirely filling the openings. In addition, the second electrode 34 may be formed using various other methods. In addition, the back surface field regions 30 may be separately formed by thermal diffusion, ion implantation, or the like and this is also within the scope of the embodiment of the invention.

In the foregoing embodiment, the back surface field regions 30 and the emitter region 20, which are conductive regions, are formed, the first and second passivation films 32 are formed, and then the first and second electrodes 24 and 34 are formed. However, the embodiments of the invention are not limited to the above example. That is, the order of formation of the emitter region 20, the back surface field regions 30, the first passivation film 22, the second passivation film 32, the first electrode 24, and the second electrode 34 may be variously changed.

In the present embodiment, various characteristics may be enhanced by improving the stacked structure of each of the first and second passivation films 22 and 32.

That is, the second layer 32b of the second passivation film 32 disposed on the back surface of the semiconductor substrate 110 is formed as a negatively charged field oxide layer and thus the second passivation film 32 may effectively passivate the conductive regions 20 and 30 of a p-type. In this regard, the first layer 32a as a neutral film having a coefficient of thermal expansion between coefficients of thermal expansion of the semiconductor substrate 110 and the second layer 32b and having a high interface trap density is formed between the second layer 32b and the semiconductor substrate 110 and thus thermal properties may be enhanced and blistering of the second layer 32b may be prevented. In addition, back reflection may be effectively implemented by adjusting indexes of refraction of the second and third layers 32b and 32c and thus light having passed through the semiconductor substrate 110 may be reused and, accordingly, the amount of light used may be increased. In addition, the fourth layer 32d acts as a capping layer and thus problems such as damage to the second passivation film 32, and the like when forming the second electrode 34 may be prevented.

In addition, dangling bonds may be removed by the first layer 22a of the first passivation film 22 disposed on the front surface of the semiconductor substrate 110, and the first passivation film 22 may serve as an anti-reflective film by restricting the indexes of refraction of the second, third and fourth layers 22b, 22c and 22d.

Particular characteristics, structures, or effects described in connection with the embodiment are included in at least one embodiment of the invention and not necessarily in all embodiments of the invention. Furthermore, the particular characteristics, structures, or effects of any specific embodiment of the invention may be combined in any suitable manner with one or more other embodiments of the invention or may be changed by those skilled in the art to which the embodiments of the invention pertain. Therefore, it is to be understood that contents associated with such combination or change fall within the spirit and scope of the embodiments of the invention.

Although embodiments of the invention have been described with reference to a number of illustrative embodiments of the invention, it should be understood that numerous other modifications and applications may be devised by those skilled in the art that will fall within the intrinsic aspects of the embodiments of the invention. More particularly, various variations and modifications are possible in concrete constituent elements of the embodiments of the invention. In addition, it is to be understood that differences relevant to the variations and modifications fall within the spirit and scope of the embodiments of the invention defined in the appended claims.

## Claims

1. A solar cell comprising:
a semiconductor substrate;
a conductive region formed at the semiconductor substrate and having a conductive type identical to or different from that of the semiconductor substrate;
a passivation film formed on the semiconductor substrate so as to cover the conductive region; and
an electrode electrically connected to at least one of the semiconductor substrate and the conductive region,
wherein the passivation film comprises:
a first layer formed on the conductive region and comprising silicon oxide;
a second layer formed on the first layer and comprising an oxide having a negative charge; and
a third layer formed on the second layer and having an index of refraction different from that of the second layer.

2. The solar cell according to claim 1, wherein the second layer comprises at least one material selected from the group consisting of aluminum oxide, hafnium oxide, and zirconium oxide.

3. The solar cell according to claim 1, wherein the first layer has a smaller coefficient of thermal expansion than the semiconductor substrate and a greater coefficient of thermal expansion than the second layer, and the first layer has a higher interface trap density than the second and third layers.

4. The solar cell according to claim 1, wherein the at least one of the following is fulfilled for the first to third layers:
wherein the first layer has a smaller thickness than each of the second and third layers;
wherein a thickness ratio of the first layer : the second layer is 1:4 to 1:12; and
wherein the first layer has a thickness of 1 nm to 5 nm.

5. The solar cell according to claim 1, wherein the passivation film is disposed on a back surface of the semiconductor substrate and the third layer has a smaller index of refraction than the second layer.

6. The solar cell according to claim 5, wherein the second layer has a smaller thickness than the third layer.

7. The solar cell according to claim 1, wherein the passivation film further comprises a fourth layer on the third layer, and
wherein the first layer comprises silicon oxide, the third layer comprises silicon oxide, and the fourth layer comprises silicon nitride.

8. The solar cell according to claim 1, wherein the passivation film further comprises a fourth layer disposed on the third layer,
wherein the second layer has an index of refraction of 1.6 to 1.8, the third layer has an index of refraction of 1.4 to 1.6, and the fourth layer has an index of refraction of 2.0 to 2.5,and
wherein the second layer has a thickness of 4 nm to 20 nm, the third layer has a thickness of 200 nm to 250 nm, and the fourth layer has a thickness of 50 nm to 100 nm.

9. The solar cell according to claim 1, wherein the conductive region comprises a first conductive region formed at a first surface of the semiconductor substrate and having a first conductive type and a second conductive region formed at a second surface of the semiconductor substrate and having a second conductive type opposite the first conductive type and further comprises a first passivation film formed on the first surface of the semiconductor substrate so as to cover the first conductive region,
wherein the passivation film is a second passivation film formed on the second surface of the semiconductor substrate so as to cover the second conductive region, and
wherein the first passivation film comprises: a first silicon oxide layer formed on the first surface of the semiconductor substrate; a silicon nitride layer formed on the first silicon oxide layer; and a second silicon oxide layer formed on the silicon nitride layer.

10. The solar cell according to claim 1, wherein the conductive region comprises a first conductive region formed at a first surface of the semiconductor substrate and having a first conductive type and a second conductive region formed at a second surface of the semiconductor substrate and having a second conductive type opposite the first conductive type,
wherein the passivation film comprises a first passivation film formed on the first surface of the semiconductor substrate so as to cover the first conductive region and a second passivation film formed on the second surface of the semiconductor substrate so as to cover the second conductive region, and
wherein each of the first passivation film and the second passivation film comprises the first layer, the second layer, and the third layer.

11. The solar cell according to claim 10, wherein the third layer of the first passivation film has a greater index of refraction than the second layer of the first passivation film, and the fourth layer of the first passivation film has a smaller index of refraction than the third layer of the first passivation film.

12. The solar cell according to claim 10, wherein the second layer of the first passivation film has a smaller thickness than the third layer of the first passivation film.

13. The solar cell according to claim 10, wherein the first passivation film further comprises a fourth layer formed on the third layer of the first passivation film,
wherein the at least one of the following is fulfilled for the second to fourth layers:
wherein the third layer of the first passivation film comprises silicon nitride, and wherein the fourth layer of the first passivation film comprises silicon oxide;
wherein the second layer of the first passivation film has an index of refraction of 1.6 to 1.8, the third layer of the first passivation film has an index of refraction of 2.0 to 2.5, and the fourth layer of the first passivation film has an index of refraction of 1.4 to 1.6; and
wherein the second layer of the first passivation film has a thickness of 4 nm to 20 nm, the third layer of the first passivation film has a thickness of 80 nm to 90 nm, and the fourth layer of the first passivation film has a thickness of 100 nm to 120 nm.

14. The solar cell according to claim 10, wherein the first surface of the semiconductor substrate is a front surface of the semiconductor substrate, the second surface of the semiconductor substrate is a back surface of the semiconductor substrate, and the first layer of the first passivation film has a smaller thickness than the first layer of the second passivation film.

15. The solar cell according to claim 1, wherein the conductive region comprises a first conductive region formed at a first surface of the semiconductor substrate and having a first conductive type and a second conductive region formed at a second surface of the semiconductor substrate and having a second conductive type opposite the first conductive type, and
wherein the second conductive region is of a p-type.
